# EUROPEAN PATENT SPECIFICATION

(11) **EP 1 474 724 B1**
(45) Date of publication and mention of the grant of the patent: **28.04.2010**
(21) Application number: 02713620.9
(22) Date of filing: 11.02.2002
(51) Int. Cl.: G03F 7/004, G03F 7/26, C08F 18/00, C08F 18/16, C08F 220/12

(54) **HALOGENATED ANTI-REFLECTIVE COATINGS**
HALOGENIERTE ANTIREFLEXBESCHICHTUNGEN
ENDUITS HALOGENES ANTIREFLECHISSANTS

(43) Date of publication of application: 10.11.2004
(60) Divisional application: 08015849.6
(73) Proprietor: Brewer Science, Inc., Rolla, MO 65401-9926 (US)
(72) Inventor: ENOMOTO, Tomoyuki, Tokyo 114-0034 (JP); MIZUSAWA, Ken-Ichi, Narashino-shi, Chiba (JP); ARASE, Shin-Ya, Midori-ku, Chiba (JP); PULIGADDA, Rama, Rolla, MO 65401 (US)
(74) Representative: UEXKÜLL & STOLBERG
(86) International application number: PCT/US2002/004690
(87) International publication number: WO 2003/075093

(56) References cited:
- DE-A1- 2 541 527
- JP-A- 2 249 541
- JP-A- 4 363 370
- JP-A- 5 150 197
- JP-A- 58 093 003
- JP-A- 62 156 105
- US-A- 4 061 829
- US-A- 5 919 599
- GOH S.H. ET AL.: 'Immiscibility window in blends of poly(hydroxy ether of bisphenol A) with poly(2,2,-dichloroethyl methacrylate-co-methyl methacrylate' MACROMOLECULES vol. 27, 1994, pages 6736 - 6739, XP002952039

## Description

### BACKGROUND OF THE INVENTION

### Field of the Invention

The present invention is broadly concerned with halogenated polymers which can be used as polymer binders in anti-reflective coatings, the resulting anti-reflective coatings, and methods of use thereof. More particularly, the inventive anti-reflective coatings comprise a polymer binder and a light attenuating compound wherein the polymer binder is halogenated, preferably on functional groups of the polymer binder. The coatings have high etch rates as well as good light-absorbing properties.

### Description of the Prior Art

Integrated circuit manufacturers are consistently seeking to maximize substrate wafer sizes and minimize device feature dimensions in order to improve yield, reduce unit case, and increase on-chip computing power. Device feature sizes on silicon or other chips are now submicron in size with the advent of advanced deep ultraviolet (DUV) microlithographic processes.

However, a frequent problem encountered by photoresists during the manufacturing of semiconductor devices is that activating radiation is reflected back into the photoresist by the substrate on which it is supported. Such reflectivity tends to cause blurred patterns which degrade the resolution of the photoresist. Degradation of the image in the processed photoresist is particularly problematic when the substrate is non-planar and/or highly reflective. One approach to address this problem is the use of an anti-reflective coating (ARC) applied to the substrate beneath the photoresist layer.

Compositions which have high optical density at the typical exposure wavelengths have been used for some time to form these anti-reflective coating (ARC) layers. The anti-reflective coating (ARC) compositions typically consist of an organic polymer which provides coating properties and a dye for absorbing light. The dye is either blended into the composition or chemically bonded to the polymer. Thermosetting anti-reflective coatings (ARCs) contain a cross-linking agent in addition to the polymer and dye. Cross-linking must be initiated, and this is typically accomplished by an acid catalyst present in the composition.

While these anti-reflective coatings (ARCs) are effective at lessening the amount of light reflected back into the photoresist, most prior art anti-reflective coating (ARC) compositions are lacking in that they do not have a sufficiently high etch rate. As a result, prior art anti-reflective coatings (ARCs) present significant limitations which make them difficult or impossible to use on submicron (e.g., 0.3 µm) features. Accordingly, there is a need for faster etching anti-reflective coatings (ARCs) which can be effectively utilized to form integrated circuits having submicron features.

Goh et al. disclose in Macromolecules 1994, vol. 27, pp. 6736 to 6739 immiscibility windows of homopolymer and copolymer blends.

Likewise, JP-A-62-156105 discloses a polymer structure.

JP-A-4-363370 discloses anti-soiling compositions useful for PVC-coated articles. It is in particular concerned with excellent stain prevention.

US-A-4 061 829 discloses negative-working photoresist compositions for X-ray or electron radiation. In particular it discloses in Example 4 a composition containing only a polymer in a solvent system along with a catalyst.

DE-A-25 41 527 discloses hydrogels for making contact lenses and biomedical membranes.

### SUMMARY OF THE INVENTION

The instant invention overcomes these problems by providing anti-reflective compositions with halogenated compounds and polymers which can be used to form anti-reflective coatings (ARC) having substantially improved etch rates when compared to prior art anti-reflective coatings (ARCs). The instant invention also provides methods of using the inventive anti-reflective coatings (ARCs) in the integrated circuit manufacturing process.

Thus, the present invention provides according to claim 1 a curable, anti-reflective composition for use during microlithographic processes, said composition comprising a polymer binder and a light attenuating compound dispersed in a solvent system, said polymer binder comprising recurring monomers according to the formula: 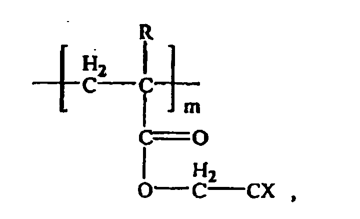 wherein R in each monomer of the polymer binder is individually selected from the group consisting of hydrogen and C₁-C₈ alkyls, and X in each monomer of the polymer binder is individually selected from the group consisting of -HI₂, -I₃, -HF₂, -F₃, -HCl₂, -Cl₃, -HBr₂, and -Br₃.

The invention also provides according to claim 16 a combination of a substrate having a surface and an anti-reflective layer on said substrate surface, said anti-reflective layer comprising therein a light attenuating compound and a polymer binder comprising recurring monomers according to the formula: 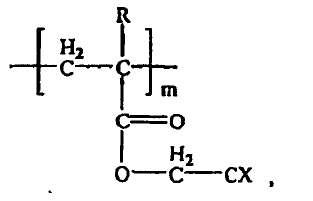 wherein R in each monomer of the polymer binder is individually selected from the group consisting of hydrogen and C₁-C₈ alkyls, and X in each monomer of the polymer binder is individually selected from the group consisting of -HI₂, -I₃, -HF₂, -F₃, -HCl₂, -Cl₃, -HBr₂, and -Br₃.

Further, the invention provides according to claim 8 a method of forming a precursor structure for use in manufacturing integrated circuits, said method comprising the step of applying a quantity of an anti-reflective composition according to claim 1 to the surface of a substrate to form an anti-reflective layer on said substrate surface.

The invention is further defined by dependent claims 2 to 5, claims 11 to 15, claim 17 and claims 20 to 24.

In more detail, the inventive anti-reflective coatings (ARCs) comprise a polymer binder and a light attenuating compound (as used herein, the term "light attenuating compound" is intended to include light absorbing compounds, chromophores, and any other compound which minimizes or prevents the transmittance of light) dissolved in a solvent system (either single or multiple solvents such as alcohols, ethers, glycol ethers, amides, esters, ketones, water, propylene glycol monomethyl ether, propylene glycol monomethyl ether acetate, ethyl lactate, and *p*-chlorobenzotrifluoride). Preferred polymer binders include each of the following in halogenated forms: polyesters, polyacrylates, polyheterocyclics, polyetherketones, polyhydroxystyrene, polycarbonates, polyepichlorohydrin, polyvinyl alcohol, oligomeric resins (such as crown ethers, cyclodextrins, epoxy resins), and mixtures of the foregoing, with acrylic polymers being particularly preferred.

The polymer binder should be present in the anti-reflective coating (ARC) at a level of from 30-90% by weight, preferably from 35-85% by weight, and more preferably from 45-85% by weight, based upon the total weight of the anti-reflective coating (ARC) taken as 100% by weight. The weight average molecular weight of the polymer binder should be from 1,000-1,000,000 g/mol (Daltons), and preferably from 3,000-200,000 g/mol (Daltons). The anti-reflective coatings (ARC's) preferably comprise from 4-35% by weight, and preferably from 8-32% by weight of a cross-linking agent, based upon the total weight of the anti-reflective coating (ARC) taken as 100% by weight. Preferred cross-lyinking agents include aminoplasts, epoxides, isocyanates, acrylics, and mixtures thereof. The inventive anti-reflective coatings (ARC's) preferably also include from 0.1-5.0% by weight, and more preferably from 0.3-4.5% by weight of a catalyst such as 2,2'-azobisisobutyronitrile. Finally, the solvent system is preferably present in the anti-reflective coating (ARC) composition at a level of from 60-99% by weight, preferably from 65-99% by weight, and more preferably from 70-98% by weight, based upon the total weight of the anti-reflective coating (ARC) taken as 100% by weight.

The polymer binder comprises halogen atoms bonded thereto, preferably in sufficient quantities so that the polymer binder comprises at least 5% by weight halogen atoms, preferably from 20-80% by weight halogen atoms, and more preferably from 30-70% by weight halogen atoms, based upon the total weight of the polymer binder taken as 100%, by weight. Preferred halogen atoms are those selected from the group consisting of fluorine, chlorine, and bromine atoms.

It is particularly preferred that the halogen atoms be bonded to a functional group on the polymer binder rather than directly to the polymer backbone (i.e., rather than to an atom which is along the direction of polymerization). Of the total halogen atoms present in the polymer binder, it is preferred that at least about 5%, preferably at least about 10%, and more preferably from 20-80% by weight of the halogen atoms be bonded to a functional group on the polymer binder, with the percentages by weight being based upon the total weight of all halogen atoms present in the polymer binder taken as 100% by weight. Even more preferably, each functional group has two and preferably three halogen atoms bonded thereto, preferably to the same carbon atom.

The polymer binder comprises recurring monomers having the formula 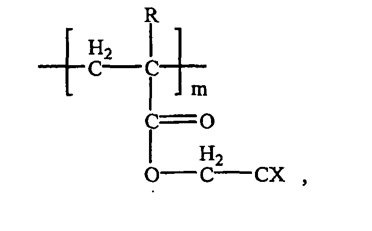 wherein: R in each monomer is individually selected from the group consisting of hydrogen and C₁-C₈ alkyls (preferably C₁-C₄ and more preferably C₁-C₂); X in each monomer is individually selected from the group consisting of -H₂I, -HI₂, -I₃, -H₂F, -HF₂, -F₃, -H₂Cl, -HCl₂, -Cl₃, ,H₂Br, -HBr₂, and -Br₃; and m is from 3-9,000, preferably from 5-5,000, and more preferably from 8-2,000.

Regardless of the embodiment, the light attenuating compound can be bonded to the polymer binder or simply mixed therewith. The light attenuating compound should be present in the polymer binder at a level of from 4-50% by weight, preferably from 10-45% by weight, and more preferably from 10-30% by weight, based upon the total weight of the polymer binder taken as 100% by weight. Preferred light attenuating compounds for use in the inventive anti-reflective coatings (ARCs) include naphthoic acid, anthracene, naphthalene, benzene, chalcone, phthalimides, pamoic acid, acridine, azo compounds, dibenzofuran, and derivatives thereof.

Those skilled in the art will appreciate that various other compounds may be added to the inventive anti-reflective coating (ARC) as desired. For example, a cross-linking agent and a catalyst for the cross-linking agent can be added to the anti-reflective coating (ARC).

The inventive anti-reflective coatings (ARCs) are formed with the above-described compounds utilizing known anti-reflective coating (ARC) preparation procedures. For example, all of the components of the anti-reflective coating (ARC) (i.e., the polymer binder, solvent system, cross-linking agent, catalyst, etc.) can be formed into a mixture and refluxed for about 24 hours under nitrogen. The polymer binders can also be prepared by known methods. For example, the desired monomers can be dissolved in a solvent and polymerized by a free radical polymerization reaction using a catalyst such as 2,2'-azobisisobutyronitrile. Those skilled in the art will appreciate that the reaction conditions, amount of catalyst, and other parameters can be adjusted to control the molecular weight of the final anti-reflective coating (ARC) composition.

The resulting anti-reflective coating (ARC) composition is subsequently applied to the surface of a substrate (e.g., silicon wafer) by conventional methods, such as by spin-coating, to form an anti-reflective coating layer on the substrate. The substrate and layer combination is baked at temperatures of at least 160°C. The baked layer will generally have a thickness of anywhere from 50 nm to 200 nm (500 Å to 2000 Å). Next, a photoresist can be applied to the anti-reflective coating (ARC) layer followed by exposing the photoresist to light at the desired wavelength, developing the exposed photoresist layer, and etching the developed photoresist layer all according to known procedures.

Anti-reflective coatings (ARCs) according to the invention have a dramatically improved etch rate, particularly those anti-reflective coatings (ARCs) where halogen atoms are bonded to functional groups of the polymer binder. Thus, the anti-reflective coatings (ARCs) have an etch selectivity to resist (i.e., the anti-reflective coating (ARC) etch rate divided by the photoresist etch rate) of at least 1.2, preferably at least 1.4, and more preferably at least 1.5 when CF₄ is used as an etchant. Alternately, the etch rate of anti-reflective coatings (ARCs) including a polymer binder halogenated on a functional group thereof is at least 10%, preferably at least 20%, and more preferably from 30-100% greater than the etch rate of an anti-reflective coating (ARC) which includes the same polymer binder without halogenated functional groups. This faster etch rate is particularly important because prior art anti-reflective coatings (ARCs) have etched substantially slower than the photoresist layer, thus resulting in overetching of the remaining photoresist layers. Use of faster etching anti-reflective coatings (ARCs) prevents degradation of the photoresist during etching, which in turn protects the device layers.

Additionally, at 248 nm the inventive anti-reflective coatings (ARCs) have a k value (i.e., the imaginary component of the complex index of refraction) of at least 0.3, and preferably at least 0.4, and have a n value (i.e., the ratio of the speed of light through a vacuum to the speed of light through the particular material) of at least 1.35, and preferably at least 1.45. Furthermore, when subjected to a stripping test as defined herein, the inventive anti-reflective coatings (ARCs) will have a stripping amount of less than 2 nm (20 Å), and preferably less than 1 nm (10 Å). Finally, the anti-reflective coatings (ARCs) give an interlayer formation result as defined herein of less than about 4 nm (40 Å), and preferably less than 3 nm (30 Å).

### DETAILED DESCRIPTION OF THE PREFERRED EMBODIMENTS

### EXAMPLES

The following examples set forth preferred methods in accordance with the invention. It is to be understood, however, that these examples are provided by way of illustration.

### PREPARATION OF MATERIALS

### 1. Monomers

### a. Trichloroethylacrylate (TCEA)

A first solution including trichloroethanol (30 g, 201 mmol) and triethylamine (22.36 g, 221 mmol) dissolved in 50 g of diethylether was prepared. A second solution comprising acryloyl chloride (20 g, 221 mmol) dissolved in 50 g of diethylether was added dropwise to the first solution followed by stirring for four hours at room temperature. The resulting solution was then added to water, and the organic phase was extracted. The organic phase was distilled to yield 32.28 g of TCEA (78.9% yield).

### b. Ti-ichloroethylmethacrylate (TCEMA)

A first solution including trichloroethanol (50 g, 335 mmol) and triethylamine (37.24 g, 368 mmol) dissolved in 50 g of diethylether was prepared. A second solution comprising methacryloyl chloride (3 8.47 g, 368 mmol) dissolved in 50 g of diethylether was added dropwise to the first solution followed by stirring for four hours at room temperature. The resulting solution was then added to water, and the organic phase was extracted. The organic phase was distilled to yield 39.33 g of TCEMA (54.0% yield).

### c. Tribromoethylacrylate (TBEA)

A first solution including tribromoethanol (50 g, 177 mmol) and triethylamine (19.73 g, 195 mmol) dissolved in 50 g of diethylether was prepared. A second solution comprising acryloyl chloride (17.65 g, 195 mmol) dissolved in 50 g of diethylether was added dropwise to the first solution followed by stirring for four hours at room temperature. The resulting solution was then added to water, and the organic phase was extracted. The organic phase was distilled to yield 48.38 g of TBEA (72.5% yield).

### d. Tribromoethylmethacrylate (TBEMA)

A first solution comprising tribromoethanol (50 g, 177 mmol) and triethylamine (19.73 g, 195 mmol) dissolved in 70 g of diethylether was prepared. A second solution comprising methacryloyl chloride (20.39 g,195 mmol) dissolved in 70 g of diethylether was added dropwise to the first solution followed by stirring for four hours at room temperature. The resulting solution was then added to water, and the organic phase was extracted. The organic phase was distilled to yield 32.85 g of TBEMA (52.9% yield).

### e. Chloroethylmethacrylate (CEMA)

A solution was prepared by dissolving 25 g of 2-chloroethanol (310 mmol) and 37.7 g of triethylamine (372.6 mmol) in 70 g of diethylether. Next, 33.72 g of chloroacrylate (272.6 mmol) dissolved in 70 g of diethylether was added drop wise to the solution at ambient temperatures with agitation being carried out for four hours. During the reaction, the reaction flask was cooled with water. The resulting solution was then washed with 300 g of water, 300 g of KHCO₃ (aq), and 300 g of NaCl (aq). The organic phase was dried with Na₂SO₄, and the diethylether was removed by distillation. The yield of the chloroethylacrylate was 91%.

### 2. Polymers

### a. Polytrifluoroethylacrylate (P-TFEA)

A solution was prepared by dissolving 30 g of trifluoroethylacrylate (195 mmol) in 111.2 g of propylene glycol monomethyl ether, with the solution being maintained at 70 °C. Next, 0.3 g of 2,2'-azobisisobutyronitrile dissolved in 10 g of propylene glycol monomethyl ether was added to this solution followed by stirring under nitrogen for 24 hours at 70°C.

### b. Polytrifluoroethylmethacrylate (P-TFEMA)

A solution was prepared by dissolving 30 g of trifluoroethylmethacrylate (178 mmol) in 111.2 g of propylene glycol monomethyl ether, with the solution being maintained at 70°C. Next, 0.3 g of 2,2'-azobisisobutyronitrile dissolved in 10 g of propylene glycol monomethyl ether was added to this solution followed by stirring under nitrogen for 24 hours at 70°C.

### c. Polytrichloroethylacrylate (P-TCEA)

A solution was prepared by dissolving 30 g of trichloroethylacrylate (147 mmol) in 111.2 g of propylene glycol monomethyl ether, with the solution being maintained at 70 °C. Next, 0.3 g of 2,2'-azobisisobutyronitrile dissolved in 10 g of propylene glycol monomethyl ether was added to this solution followed by stirring under nitrogen for 24 hours at 70°C.

### d. Polytrichloroethylmethacrylate (P-TCEMA)

A solution was prepared by dissolving 30 g of trichloroethylmethacrylate (138 mmol) in 111.2 g of propylene glycol monomethyl ether, with the solution being maintained at 70°C. Next, 0.3 g of 2,2'-azobisisobutyronitrile dissolved in 10 g of propylene glycol monomethyl ether was added to this solution followed by stirring under nitrogen for 24 hours at 70°C.

### e. Polytrichloroethylmethacrylate (P-TCEMA)

A solution was prepared by dissolving 30 g of trichloroethylmethacrylate (138 mmol) in 111.2 g of propylene glycol monomethyl ether, with the solution being maintained at 50°C. Next, 0.3 g of 2,2'-azobis-(2,4-dimethyl valeronitrile) dissolved in 10 g of propylene glycol monomethyl ether was added to this solution followed by stirring under nitrogen for 24 hours at 50°C.

### f. Polytribromoethylacrylate (P-TBEA)

A solution was prepared by dissolving 30 g of tribromoethylacrylate (89 mmol) in 111.2 g of propylene glycol monomethyl ether, with the solution being maintained at 70°C. Next, 0.3 g of 2,2'-azobisisobutyronitrile dissolved in 10 g of propylene glycol monomethyl ether was added to this solution followed by stirring under nitrogen for 24 hours at 70°C.

### g. Polychloroethylacrylate (P-CEA)

A solution was prepared by dissolving 20 g of chloroethylacrylate (148.6 mmol) in 61.51 g of propylene glycol monomethyl ether (PGME), with the solution being maintained at 70°C. Next, 0.01 g of 2,2'-azobisisobutyronitrile dissolved in 6.7 g of PGME was added to the solution. The resulting solution was stirred under nitrogen for 24 hours at 70°C.

### h. Polybromoarylate (P-BA)

A solution of 20 g of methacrylate (249.8 mmol) dissolved in 80 g of diethylether was prepared. A second solution containing 40.83 g of bromine (255 mmol) dissolved in 200 g of diethylether was added drop wise to the first solution under ambient temperatures with agitation of the resulting solution being carried out for one hour. During the reaction, the reaction flask was cooled with water. The resulting solution was washed with water, KHCO₃ (aq), and water again, in order. The organic phase was dried with Na₂SO₄, and the diethylether was removed by distillation. Thirty grams of the resulting compound was mixed with 40.5 g of 3N NaOH (aq) under agitation. The reaction flask was cooled with ice water throughout the eight-hour reaction. The polymer precipitated in the reaction solution, and was then dissolved in dimethyl formamide (DMF) and reprecipitated in 700 ml of methanol. The yield of the polymer was 20.5%.

### 3. Copolymers

### a. Copolytrifluoroethylmethacrylate/glycidylmethacrylate(65/35 mol/mol) (P-TFEMA/GMA (65/35))

A solution was prepared by dissolving 26.01 g of trifluoroethylmethacrylate (155 mmol) and 11.83 g of glycidylmethacrylate (83 mmol) in 142.88 g of propylene glycol monomethyl ether, with the solution being maintained at 70°C. Next, 0.38 g of 2,2'-azobisisobutyronitrile dissolved in 10 g ofpropylene glycol monomethyl ether was added to this solution followed by stirring under nitrogen for 24 hours at 70°C.

### b. Copolytrichloroethylmethacrylate/glycidylmethacrylate (65/35 mol/mol) (P-TCEMA/GMA (65/35))

A solution was prepared by dissolving 20 g of trichloroethylmethacrylate (92 mmol) and 7.04 g of glycidylmethacrylate (50 mmol) in 99.24 g of propylene glycol monomethyl ether, with the solution being maintained at 70°C. Next, 0.27 g of 2,2'-azobisisobutyronitrile dissolved in 10 g of propylene glycol monomethyl ether was added to this solution followed by stirring under nitrogen for 24 hours at 70°C.

### c. Copolytrichloroethylmethacrylate/glycidylmethaclylate (65135 mol/mol) (P-TCEMA/GMA (65/35))

A solution was prepared by dissolving 20 g of trichloroethylmethacrylate (92 mmol) and 7.04 g of glycidylmethacrylate (50 mmol) in 99.24 g of propylene glycol monomethyl ether, with the solution being maintained at 50°C. Next, 0.27 g of 2,2'-azobis-(2,4-dimethyl valeronitrile) dissolved in 10 g of propylene glycol monomethyl ether was added to this solution followed by stirring under nitrogen for 24 hours at 50°C.

### d. Copolytrichloroethylacrylate/glycidylmethacrylate (65/35 mol/mol) (P-TCEAlGMA (65/35))

A solution was prepared by dissolving 10g of trichloroethylacrylate (49 mmol) and 3.76 g of glycidylmethacrylate (27 mmol) in 45.6 g of propylene glycol monomethyl ether, with the solution being maintained at 70°C. Next, 0.14 g of 2,2'-azobisisobutyronitrile dissolved in 10g of propylene glycol monomethyl ether was added to this solution followed by stirring under nitrogen for 24 hours at 70°C.

### e. Copolytribromoethylacrylate/glycidylmethacrylate (65/35 mol/mol) (P-TBEMA/GMA (65/35))

A solution was prepared by dissolving 20 g of tribromoethylacrylate (59 mmol) and 4.55 g of glycidylmethacrylate (32 mmol) in 89.2 g of propylene glycol monomethyl ether, with the solution being maintained at 70°C. Next, 0.25 g of 2,2'-azobisisobutyronitrile dissolved in 10 g of propylene glycol monomethyl ether was added to this solution followed by stirring under nitrogen for 24 hours at 70°C.

### f. Copolytrichloroethylmethacrylate/glycidylmethacrylate (70/30 mol/mol) (P-TCEMAIGMA (70/30))

A solution was prepared by dissolving 10.82 g of trichloroethylmethacrylate (50 mmol) and 3.03 g of glycidylmethacrylate (21 mmol) in 45.95 g of propylene glycol monomethyl ether, with the solution being maintained at 50°C. Next, 0.14 g of 2,2'-azobis-(2,4-dimethyl valeronitrile) dissolved in 10 g of propylene glycol monomethyl ether was added to this solution followed by stirring under nitrogen for 24 hours at 50°C.

### g. Copolytrichloroethylmethacrylate/glycidylmethacrylate (75/25 mol/mol) (P-TCEMAlGMA (75125))

A solution was prepared by dissolving 13.39 g of trichloroethylmethacrylate (62 mmol) and 2.91 g of glycidylmethacrylate (21 mmol) in 55.85 g of propylene glycol monomethyl ether, with the solution being maintained at 50°C. Next, 0.16 g of 2,2'-azobis-(2,4-dimethyl valeronitrile) dissolved in 10 g of propylene glycol monomethyl ether was added to this solution followed by stirring under nitrogen for 24 hours at 50°C.

### h. Copoly-VC/GMA

In this preparation, 8.03 g of vinylidenedichloride (83 mmol), 11.77 g of glycidylmethacrylate (83 mmol), 0.20 g of 2,2'-azobisisobutyronitrile (1.21 mmol), and 80 g of dioxane were charged into a 200 ml autoclave followed by stirring for 24 hours at 70°C and under nitrogen.

### i. Copoly-VC/MAL

In this preparation, 9.85 g of vinylidenedichloride (102 mmol), 9.95 g of maleic anhydride (102 mmol), 0.20 g of 2,2'-azobisisobutyronitrile (1.21 mmol), and 80 g of dioxane were charged into a 200 ml autoclave followed by stirring for 24 hours at 70°C and under nitrogen.

### 4. Anti-reflective Coatings (ARCs)

### a. Anti-reflective Coating (ARC) containing copolytrifluoroethylmethacrylate/ glycidylmethacrylate - Anti-reflective Coating (ARC) [P-TFEMA/GMA (65/35)]

A mixture of 20 g P-TFEMA/GMA (65/35) in 80 g of propylene glycol monomethyl ether (epoxy value = 0.4403), 9 g of 9-anthracenecarboxylic acid (41 mmol), 0.24 g benzyltriethylammoniumchloride (1.1 mmol), and 36.96 g of propylene glycol monomethyl ether was refluxed for 24 hours under nitrogen.

### b. Anti-reflective Coating (ARC) containing copolytrichloroethylmethacrylate/ glycidylmethacrylate - Anti-reflective Coating (ARC) [P-TCEMA/GMA (65/35)]

A mixture of 4 g P-TCEMA/GMA (65/35) in 16 g of propylene glycol monomethyl ether (epoxy value = 0.3663), 1.5 g of 9-anthracenecarboxylic acid (6.7 mmol), 0.04 g benzyltriethylammoniumchloride (0.18 mmol), and 6.16 g of propylene glycol monomethyl ether was refluxed for 24 hours under nitrogen.

### c. Anti-reflective Coating (ARC) containing copolytrichloroethylacrylate/ glycidylmethacrylate Anti-reflective Coating (ARC) [P-TCEAlGMA (65/35)]

A mixture 4 g of P-TCEA/GMA (65/35) in 16 g of propylene glycol monomethyl ether (epoxy value = 0.3845), 1.6 g of 9-anthracenecarboxylic acid (7.1 mmol), 0.04 g benzyltriethylammoniumchloride (0.18 mmol), and 6.56 g of propylene glycol monomethyl ether was refluxed for 24 hours under nitrogen.

### d. Anti-reflective Coating (ARC) containing copolytrichloroethylmethacrylate/ glycidylmethacrylate Anti-reflective Coating (ARC) [P-TCEMA/GMA (70/30)]

A mixture of 4 g of P-TCEMA/GMA (70/30) in 16 g of propylene glycol monomethyl ether (epoxy value = 0.3079), 1.26 g of 9-anthracenecarboxylic acid (5.7 mmol), 0.03 g benzyltriethylammoniumchloride (0.15 mmol), and 5.16 g of propylene glycol monomethyl ether was refluxed for 24 hours under nitrogen.

### e. Anti-reflective Coating (ARC) containing copolytrichloroethylmethacrylate/ glycidylmethacrylate - Anti-reflective Coating (ARC) [P-TCEMA/GMA (75/25)]

A mixture of 4 g of P-TCEMA/GMA (75/25) in 16 g of propylene glycol monomethyl ether (epoxy value = 0.2517), 1.03 g of 9-anthracenecarboxylic acid (4.6 mmol), 0.03 g benzyltriethylammoniumchloride (0.12 mmol), and 4.24 g of propylene glycol monomethyl ether was refluxed for 24 hours under nitrogen.

### TESTING PROCEDURES

### 1. Stripping Test Procedure

In some of the following examples, a stripping test was performed to determine the resistance of the experimental anti-reflective coating (ARC) to photoresist solvents. In this procedure, the anti-reflective coating (ARC) formulation was spin-coated onto a silicon wafer at a spin speed of 2,500 rpm for 60 seconds and at an acceleration of 20,000 rpm/second. The film was baked on a hotplate at 205°C for 60 seconds. The anti-reflective coating (ARC) film thickness was then measured at multiple points on the wafer using ellipsometry.

Ethyl lactate was puddled onto the silicon wafer for 10 seconds, followed by spin drying at 3,500 rpm for 30 seconds to remove the solvent. The film was then baked on a hotplate at 100°C for 30 seconds. The anti-reflective coating (ARC) film thickness was again measured at multiple points on the wafer using ellipsometry. The amount of stripping was determined to be the difference between the initial and final average film thicknesses. A stripping test result of less than 2 nm (20 A) was considered acceptable.

### 2. Interlayer Formation Procedure

In some of the following examples, the degree of intermixing between the sample anti-reflective coating (ARC) and the photoresist was determined. In this procedure, the anti-reflective coating (ARC) formulation was spin-coated onto a silicon wafer at a spin speed of 2,500 rpm for 60 seconds and at an acceleration of 20,000 rpm/second. The film was baked on a hotplate at 205°C for 60 seconds. The anti-reflective coating (ARC) film thickness was then measured at multiple points on the wafer using ellipsometry.

A photoresist (UV6, available from Shipley) was spin-coated on top of the anti-reflective coating (ARC) film at a spin speed of 3250 rpm for 30 seconds and at an acceleration of 20,000 rpm/second under ambient conditions. The wafer was then baked on a hotplate for 130°C for 60 seconds and exposed to 20 mJ of exposure energy, after which a post-exposure bake was performed on the wafer at 130°C for 90 seconds.

The photoresist was developed with Shipley LDD26W developer for 40 seconds. The sample was then rinsed with distilled water and spun dry at 2,000 rpm for 20 seconds followed by baking on a hotplate for 100°C for 30 seconds. The film thickness was again measured at multiple points on the wafer using ellipsometry. The difference in the two film thickness averages nm (A) was recorded as the interlayer formation result.

### 3. Etching Condition

In each of the following examples the etch rate and etch selectivity was determined by etching the particular layer with an RIE System ES401 (Nippon Scientific Company, Ltd.) using the particular etchant indicated in the tables. This was accomplished by spin-coating the sample onto a silicon wafer and measuring the thickness of the layer on the wafer (this value was designated as "A"). The layer was then etched, and the thickness was measured after etching (this value was designated as "B"). The etch rate was calculated as follows: (A-B)/etching time (min). The etch selectivity was then calculated as follows: (etch rate of the sample)/(etch rate of a control).

### EXAMPLE 1

In this example, homopolymers were halogenated on a functional group of the homopolymer (i.e., the halogens were not attached directly to the polymer backbone), and the etch selectivity of the halogenated homopolymer was determined. The tested homopolymers are represented by Formula I. The etch selectivity results are set forth in Table 1. These results indicate that the etch rate dramatically increased as the number of halogens bonded to a particular homopolymer functional group increased. Additionally, the etch rate increased as the molecular weight of the substituted halogens increased. 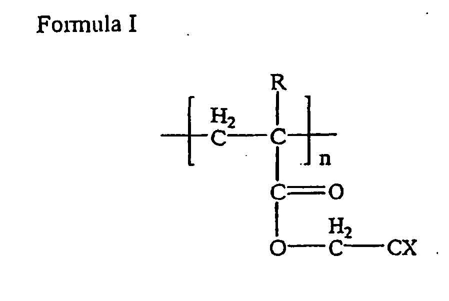 Where R is -H or -CH₃ and X is -F₃,-Cl₃,-H₂Cl, or -Br₃, as indicated in Table 1.

**Table 1. The Etch Selectivity of Halogenated Acrylic Homopolymers.**

| | | | | |
|---|---|---|---|---|
| X= -F3 | | | R= -CH₃ | R= -H |
| | homopolymer name | | P-TFEMA | P-TFEA |
| | MW/MN^{a} | | 31,000/15,000 (2.07)^{b} | 18,000/8,500 (2.12) |
| | n value (at 248 nm) | | 1.47 | 1.48 |
| | etch selectivity (CF₄)^{c} | | | |
| | | with CD11^{d} | 2.30 | 2.68 |
| | | with P-HPMA | 1.29 | 1.51 |
| | etch selectivity (CF₄/O₂=9/l)^{e} | | | |
| | | with CD11 | 2.29 | 2.35 |
| | | with P-HPMA | 1.15 | 1.18 |
| X= -Cl₃ | | | R= -CH₃ | R= -H |
| | homopolymer name | | P-TCEMA | P-TCEA |
| | MW/MN | | 47,000/18,000 (2.70) | 9,800/3,700 (2.65) |
| | n value (at 248 nm) | | 1.60 | 1.62 |
| | etch selectivity (CF₄) | | | |
| | | with CD11 | 3.09 | 3.35 |
| | | with P-HPMA | 1.74 | 1.88 |
| | etch selectivity (CF₄/O₂=9/1) | | | |
| | | with CD11 | 2.54 | 2.33 |
| | | with P-HPMA | 1.28 | 1.17 |
| X= -H₂Cl | | | R= -CH₃ | R= -H |
| | homopolymer name | | P-CEMA | P-CEA |
| | MW/MN | | -- | 50,000/9,800 (5.10) |
| | n value (at 248 nm) | | -- | 1.59 |
| | etch selectivity (CF₄) | | | |
| | | with CD11 | -- | 2.11 |
| | | with P-HPMA | -- | 1.19 |
| | etch selectivity (CF₄/O₂=9/1) | | | |
| | | with CD11 | -- | 2.03 |
| | | with P-HPMA | - | 1.02 |
| X= -Br₃ | | | R= -CH₃ | R= -H |
| | homopolymer name | | P-TBEMA | P-TBEA |
| | MW/MN | | -- | 31,000/6,300 (4.92) |
| | n value (at 248 nm) | | - | 1.75 |
| | etch selectivity (CF₄) | | | |
| | | with CD11 | - | 3.38 |
| | | with P-HPMA | - | 1.90 |
| | etch selectivity (CF₄/O₂=9/1) | | | |
| | | with CD11 | -- | 2.67 |
| | | with P-HPMA | -- | 1.34 |
| reference | | | R= -CH₃ | |
| | homopolymer name | | P-HPMA | |
| | MW/MN | | 39,000/17,000 (2.29) | |
| | n value (at 248 nm) | | 1.58 | |
| | etch selectivity (CF₄) | | | |
| | | with CD11 | 1.78 | |
| | | with P-HPMA | 1.00 | |
| | etch selectivity (CF₄/O₂=9/1) | | | |
| | | with CD11 | 1.99 | |
| | | with P-HPMA | 1.00 | |

| | | | | |
|---|---|---|---|---|
| ^{a} Molecular weight average/number average. ^{b} The number in parenthesis corresponds to MW ö MN. ^{c} Indicates the etchant used in this test. ^{d} An anti-reflective coating useful for absorbing light at 248 nm and available from Brewer Science, Inc. ^{e} Indicates weight ratio of components of etchant in this test. ^{f} The reference was P-HPMA which comprises monomers of the formula | | | | |

### EXAMPLE 2

In this example, copolymers were halogenated on the backbone of the copolymer, and the etch selectivity of the halogenated copolymer was determined as compared to a reference (P-HPMA). The tested copolymers are represented by Formulas II-IV. The etch selectivity results are set forth in Table 2. The etch rate was not improved or only mildly improved when halogens were added directly to the polymer backbone.

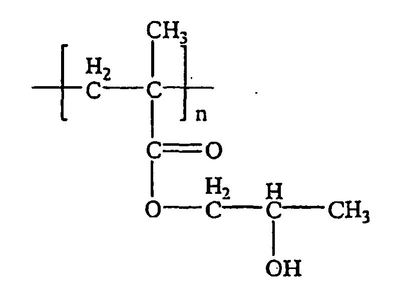

Poly-hydroxypropylmethacrylate (P-HPMA)

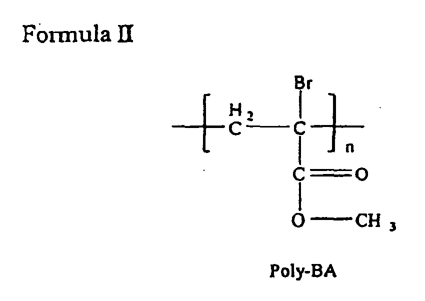

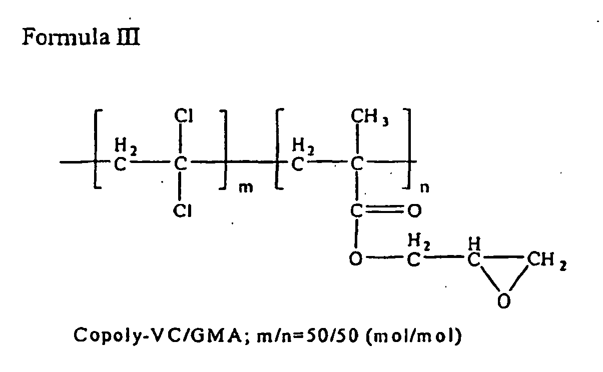

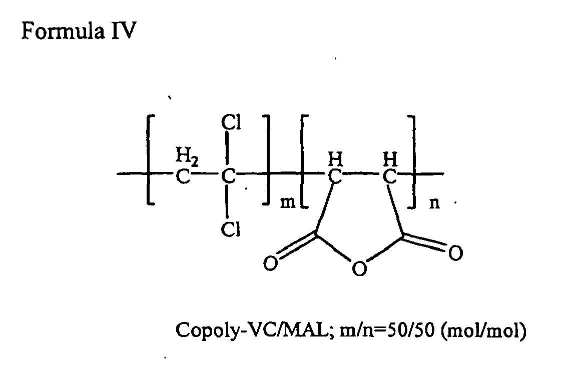

**Table 2. The Etch Selectivity of Halogenated Acrylic Homopolymers.**

| copolymer name | | Poly-BA | Copoly-VC/GMA | Copoly-VC/MAL |
|---|---|---|---|---|
| MW/NIN^{a} | | 30,000/12,000 | 17,000/5,800 | 43,000/2,300 |
| | | (2.46)^{b} | (2.97) | (1.85) |
| n value (at 248 nm) | | 1.65 | 1.63 | 1.71 |
| etch selectivity (CF₄)^{c} | | | | |
| | with CD11 | 2.01 | 1.77 | 2.20 |
| | with P-HPMA | 1.13 | 1.00 | 1.24 |
| etch selectivity (CF₄/O₂=9/1)^{d} | | | | |
| | with CD11 | -- | 1.70 | -- |
| | with P-HPMA | -- | 0.85 | -- |

| | | | | |
|---|---|---|---|---|
| ^{a} Molecular weight average/number average. ^{b} The number in parenthesis corresponds to MW ö MN. ^{c} Indicates the etchant used in this test. ^{d} Indicates weight ratio of components of etchant in this test. | | | | |

### EXAMPLE 3

In this example, copolymers were halogenated on functional groups of the copolymer (i.e., the halogens were not attached directly to the polymer backbone) which was grafted with a chromophore. The respective etch selectivities of the resulting anti-reflective coatings (ARCs) were determined as compared to a reference (DUV42, see Formula V). The tested copolymers are represented by Formula VI. The etch selectivity results are set forth in Table 3.

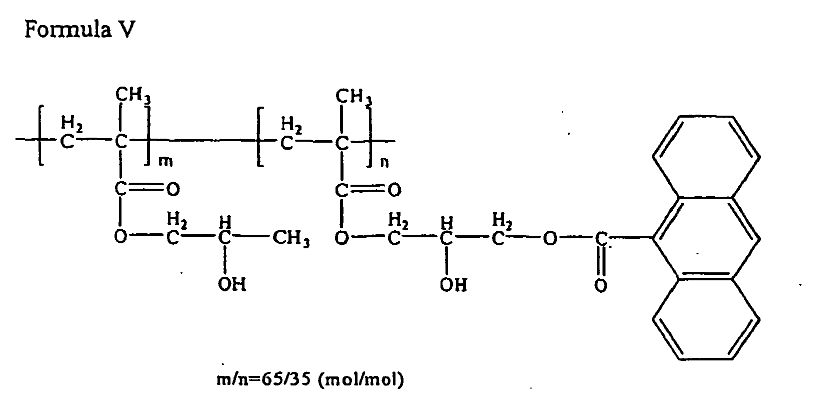

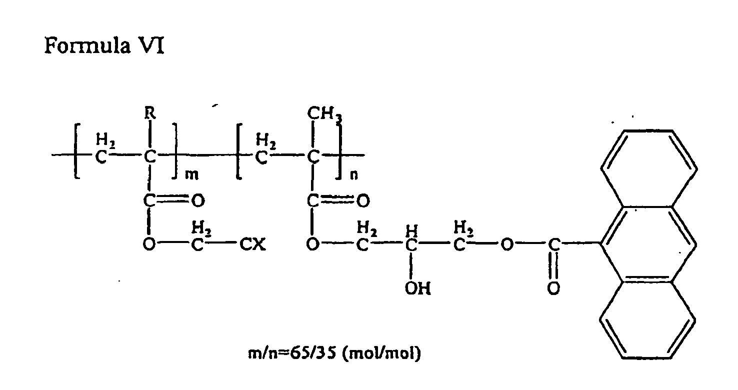

Where "R" is -H or -CH₃, and "X" is -F₃ or -Cl₃, as indicated in Table 3.

**Table 3. The Etch Selectivity, n value, and k value of Halogenated Anti-reflective Coatings (ARCs)**

| Base Polymer | | Copoly-TFEMA/GMA^{a} | Copoly-TCEMA/GMA^{b} | Copoly-TCEA/GMA^{c} | DUV42 (reference) |
|---|---|---|---|---|---|
| n value (at 248 nm) | | 1.47 | 1.49 | 1.47 | 1.48 |
| k value (at 248 nm) | | 0.475 | 0.444 | 0.467 | 0.495 |
| etch selectivity (CF₄)^{d} | | | | | |
| | with CD11 | 1.44 | 1.59 | 1.57 | 1.29 |
| | with DUV42 | 1.12 | 1.22 | 1.21 | 1.00 |
| | with APEX-E^{e} | 1.53 | 1.69 | 1.67 | 1.37 |
| etch Selectivity (CF₄/O₂=9/1)^{f} | | | | | |
| | with CD11 | 1.48 | 1.51 | 1.51 | 1.38 |
| | with DUV42 | 1.07 | 1.09 | 1.09 | 1.00 |
| | with APEX-E | 1.59 | 1.62 | 1.62 | 1.48 |

| | | | | | |
|---|---|---|---|---|---|
| ^{a} Formula VI, where "R" is -CH₃ and "X" is -F₃. ^{b} Formula VI, where "R" is -CH₃ and "X" is -Cl₃. ^{c} Formula VI, where "R" is -H and "X" is -Cl₃. ^{d} Indicates the etchant used in this test. ^{e} A photoresist available from Shipley. ^{f} Indicates weight ratio of components of etchant in this test. | | | | | |

### EXAMPLE 4

In this example, copolymers were halogenated on a functional group of the copolymer (i.e., the halogens were not attached directly to the polymer backbone) which was grafted with a chromophore similar to Example 3. The etch selectivity of the anti-reflective coating (ARC) was then determined. The copolymers of the polymer binder in the tested anti-reflective coating (ARC) are represented by Formula VII, with varying molar ratios of "m" and "n" being tested. The etch selectivity results are set forth in Table 4. These results indicate that anti-reflective coatings (ARCs) formed with polymers having halogentated functional groups can have the molar ratio of the copolymer members varied to adjust the properties of the anti-reflective coating (ARC).

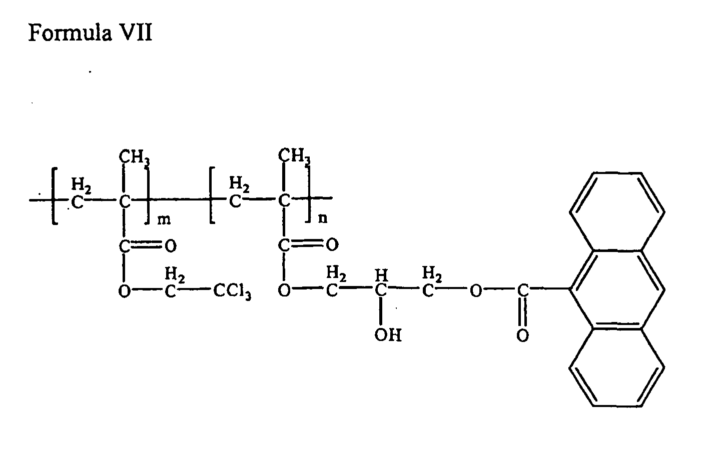

**Table 4. The Etch Selectivity, n value, and k value of Halogenated Anti-reflective Coatings (ARCs)**

| | | | | | |
|---|---|---|---|---|---|
| Polymer solid/PWL^{a} =4.13/0.2 (wt/wt) PWL/pTSA^{b} =10/1 (wt/wt) | m/n (mol/mol) | | 65/35 | 70/30 | 75/25 |
| | n value (at 248 nm) | | 1.48 | 1.50 | 1.52 |
| | k value (at 248 nm) | | 0.491 | 0.431 | 0.365 |
| | stripping test | | Okay^{c} | Okay | Okay |
| | interlayer test (Å) nm | | 2.9 (29) | 3.0 (30) | 5.1 (51) |
| | etch selectivity (CF₄)^{d} | | | | |
| | | with CD11 | 1.57 | 1.66 | 1.76 |
| | | with DUV42 | 1.21 | 1.28 | 1.35 |
| | | with APEX-E | 1.67 | 1.77 | 1.87 |
| | etch selectivity (CF₄/O₂=9/1)^{e} | | | | |
| | | with CD11 | 1.52 | 1.60 | 1.69 |
| | | with DUV42 | 1.10 | 1.16 | 1.22 |
| | | with APEX-E | 1.63 | 1.72 | 1.82 |
| Polymer solid/PW L =4.13/0.5 (wt/wt) PWL/pTSA =10/1 (wt/wt) | m/n (mol/mol) | | 65/35 | 70/30 | 75/25 |
| | n value (at 248 nm) | | 1.48 | 1.48 | 1.50 |
| | k value (at 248 nm) | | 0.485 | 0.441 | 0.354 |
| | stripping test | | Okay | Okay | Okay |
| | interlayer test (Å) nm | | 1.3 (13) | 1.8 (18) | 2.2 (22) |
| | etch selectivity (CF₄) | | | | |
| | | with CD11 | 1.58 | 1.65 | 1.75 |
| | | with DUV42 | 1.22 | 1.27 | 1.35 |
| | | with APEX-E | 1.68 | 1.76 | 1.86 |
| | etch selectivity (CF₄/O₂=9/1) | | | | |
| | | with CD11 | 1.51 | 1.58 | 1.63 |
| | | with DUV42 | 1.09 | 1.14 | 1.18 |
| | | with APEX-E | 1.62 | 1.70 | 1.75 |
| Polymer solid/PWL =4.13/1 (wt/wt) PWL/pTSA =10/1 (wt/wt) | m/n (mol/mol) | | 65/35 | 70/30 | 75/25 |
| | n value (at 248 nm) | | 1.48 | 1.49 | 1.50 |
| | k value (at 248 nm) | | 0.444 | 0.392 | 0.332 |
| | stripping test | | Okay | Okay | Okay |
| | interlayer test (Å) nm | | 1.3 (13) | 1.4 (14) | 2.1 (21) |
| | etch selectivity (CF₄) | | | | |
| | | with CD11 | 1.59 | 1.68 | 1.81 |
| | | with DUV42 | 1.22 | 1.29 | 1.39 |
| | | with APEX-E | 1.69 | 1.79 | 1.93 |
| | etch selectivity (CF₄/O₂=9/1) | | | | |
| | | with CD11 | 1.51 | 1.59 | 1.68 |
| | | with DUV42 | 1.09 | 1.15 | 1.22 |
| | | with APEX-E | 1.62 | 1.71 | 1.81 |
| Polymer solid/PWL =4.13/2 (wt/wt) PWL/pTSA =10/1 (wt/wt) | m/n (mol/mol) | | 65/35 | 70/30 | 75/25 |
| | n value (at 248 nm) | | 1.51 | 1.52 | 1.52 |
| | k value (at 248 nm) | | 0.402 | 0.358 | 0.297 |
| | stripping test | | Okay | Okay | Okay |
| | interlayer test (Å) nm | | 1.3 (13) | 1.7 (17) | 2.0 (20) |
| | etch selectivity (CF₄) | | | | |
| | | with CD11 | 1.66 | 1.73 | 1.86 |
| | | with DUV42 | 1.28 | 1.33 | 1.43 |
| | | with APEX-E | 1.77 | 1.84 | 1.98 |
| | etch selectivity (CF₄/O₂=9/1) | | | | |
| | | with CD11 | 1.57 | 1.70 | 1.74 |
| | | with DUV42 | 1.14 | 1.23 | 1.26 |
| | | with APEX-E | 1.69 | 1.83 | 1.87 |
| Polymer solid/CYM^{f} =7.6/1 (wt/wt) CYM/pTSA =25/1 (wt/wt) | m/n (mol/mol) | | 65/35 | 70/30 | 75/25 |
| | n value (at 248 nm) | | 1.51 | -- | -- |
| | k value (at 248 nm) | | 0.460 | -- | - |
| | stripping test | | Okay | -- | - |
| | interlayer test (Å) nm | | 2.0 (20) | -- | -- |
| | etch selectivity (CF₄) | | | | |
| | | with CD11 | 1.67 | -- | -- |
| | | with DUV42 | 1.28 | -- | -- |
| | | with APEX-E | 1.78 | -- | -- |
| | etch selectivity (CF₄/O₂=9/1) | | | | |
| | | with CD11 | 1.50 | -- | -- |
| | | with DUV42 | 1.09 | -- | -- |
| | | with APEX-E | 1.61 | -- | -- |

| | | | | | |
|---|---|---|---|---|---|
| ^{a} PWL is a cross-linker available from CYTEC Industries. ^{b} *p*-toluenesulfonic acid. ^{c} Indicates a stripping test result of less than (10 Å) 1.0 nm ^{d} Indicates etchant utilized. ^{e} Indicates weight ratio of components of etchant in this test. ^{f} CYM is a cross-linker available from CYTEC Industries. | | | | | |

## Claims

1. A curable, anti-reflective composition for use during microlithographic processes, said composition comprising a polymer binder and a light attenuating compound dispersed in a solvent system, said polymer binder comprising recurring monomers according to the formula: 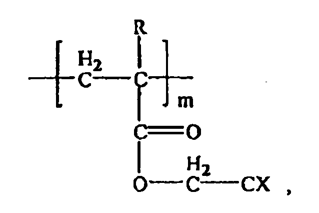 wherein R in each monomer of the polymer binder is individually selected from the group consisting of hydrogen and C₁-C₈ alkyls, and X in each monomer of the polymer binder is individually selected from the group consisting of -HI₂, -I₃, -HF₂, -F₃, -HCl₂, -Cl₃, -HBr₂, and -Br₃.

2. The composition of claim 1, wherein said light attenuating compound is bonded to the polymer binder.

3. The composition of claim 1, wherein said composition further comprises a cross-linking agent and a catalyst for said cross-linking agent.

4. The composition of claim 1, wherein said composition has an etch selectivity to resist of at least 1.2 when CF₄ is used as an etchant.

5. The composition of claim 1, wherein the weight average molecular weight of said polymer binder is from 1,000 - 1,000,000 g/mol (Daltons).

6. The composition of claim 1, wherein said composition has a k value of at least 0.3 at 248 nm.

7. The composition of claim 1, wherein said composition has an n value of at least 1.35 at 248 nm.

8. A method of forming a precursor structure for use in manufacturing integrated circuits, said method comprising the step of applying an anti-reflective composition according to claim 1 to the surface of a. substrate to form an anti-reflective layer on said substrate surface.

9. The method of claim 8, wherein said anti-reflective layer has a k value of at least 0.3 at 248 nm.

10. The method of claim 8, wherein said composition has a n value of at least 1.35 at 248 nm.

11. The method of claim 8, wherein said applying step comprises spin-coating said composition on said substrate surface.

12. The method of claim 8, further including the step of baking said anti-reflective layer after said applying step at a temperature of at least 160°C.

13. The method of claim 12, further including the step of applying a photoresist to said anti-reflective layer.

14. The method of claim 13, further including the steps of:
exposing at least a portion of said photoresist layer to activating radiation;
developing said exposed photoresist layer; and
etching said developed photoresist layer.

15. The method of claim 8, wherein said anti-reflective layer has an etch selectivity to resist of at least 1.2 when CF₄ is used as an etchant.

16. The combination of a substrate having a surface and an anti-reflective layer on said substrate surface, said anti-reflective layer comprising therein a light attenuating compound and a polymer binder comprising recurring monomers according to the formula: 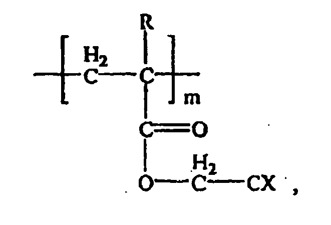 wherein R in each monomer of the polymer binder is individually selected from the group consisting of hydrogen and C₁-C₈ alkyls, and X in each monomer of the polymer binder is individually selected from the group consisting of -HI₂, -I₃, -HF₂, -F₃, -HCl₂, -Cl₃, -HBr₂, and -Br₃.

17. The combination of claim 16, wherein said anti-reflective layer has an etch selectivity to resist of at least 1.2 when CF₄ is used as an etchant.

18. The combination of claim 16, wherein said anti-reflective layer has a k value of at least 0.3 at 248 nm.

19. The combination of claim 16, wherein said anti-reflective layer has a n value of at least 1.4 at 248 nm.

20. The composition of claim 1, wherein said polymer binder comprises from 20-80% by weight halogen atoms, based upon the total weight of the polymer binder taken as 100% by weight.

21. A method of forming a precursor structure for use in manufacturing integrated circuits, said method comprising the step of applying an anti-reflective composition according to claim 20 to the surface of a substrate to form an anti-reflective layer on said substrate surface.

22. The method of claim 21, further including the step of applying a photoresist to said anti-reflective layer.

23. The method of claim 22, furthering including the steps of:
exposing at least a portion of said photoresist layer to activating radiation;
developing said exposed photoresist layer; and
etching said developed photoresist layer.

24. The combination of claim 16, wherein
said polymer binder comprises from 20-80% by weight halogen atoms, based upon the total weight of the polymer binder taken as 100% by weight.

## Patentansprüche

1. Härtbare Antireflexzusammensetzung zur Verwendung bei mikrolithographischen Verfahren, wobei die Zusammensetzung Polymerbindemittel und eine lichtdämpfende Verbindung enthält, die in einem Lösungsmittelsystem dispergiert sind, wobei das Polymerbindemittel wiederkehrende Monomere der Formel: 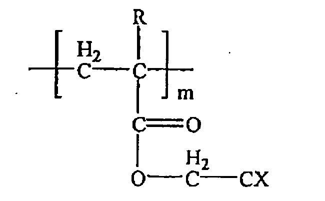 umfasst, in der R in jedem Monomer des Polymerbindemittels individuell aus der Gruppe bestehend aus Wasserstoff und C₁-bis C₈-Aklylgruppen ausgewählt ist und X in jedem - Monomer des Polymerbindemittels individuell aus der Gruppe bestehend aus -HI₂, -I₃, -HF₂, -F₃, -HCl₂, -Cl₃, -HBr₂ und -Br₃ ausgewählt ist.

2. Zusammensetzung nach Anspruch 1, bei der die lichtdämpfende Verbindung an das Polymerbindemittel gebunden ist.

3. Zusammensetzung nach Anspruch 1, bei der die Zusammensetzung ferner Vernetzungsmittel und Katalysator für das Vernetzungsmittel enthält.

4. Zusammensetzung nach Anspruch 1, bei der die Zusammensetzung eine Ätzselektivität gegenüber dem Resist von mindestens 1,2 aufweist, wenn als Ätzmittel CF₄ verwendet wird.

5. Zusammensetzung nach Anspruch 1, bei der das gewichtsgemittelte Molekulargewicht des Polymerbindemittels 1000 bis 1000000 g/mol (Daltons) beträgt.

6. Zusammensetzung nach Anspruch 1, bei der die Zusammensetzung einen k-Wert von mindestens 0,3 bei 248 nm aufweist.

7. Zusammensetzung nach Anspruch 1, bei der die Zusammensetzung einen n-Wert von mindestens 1,35 bei 248 nm aufweist.

8. Verfahren zum Bilden einer Vorläuferstruktur zur Verwendung beim Herstellen von integrierten Schaltungen, wobei bei dem Verfahren eine Antireflexzusammensetzung gemäß Anspruch 1 auf die Oberfläche eines Substrats aufgebracht wird, um auf der Substratoberfläche eine Antireflexschicht zu bilden.

9. Verfahren nach Anspruch 8, bei dem die Antireflexschicht einen k-Wert von mindestens 0,3 bei 248 nm aufweist.

10. Verfahren nach Anspruch 8, bei dem die Zusammensetzung einen n-Wert von mindestens 1,35 bei 248 nm aufweist.

11. Verfahren nach Anspruch 8, bei dem die Zusammensetzung mittels Rotationsbeschichtung auf die Substratoberfläche aufgebracht wird.

12. Verfahren nach Anspruch 8, bei dem ferner die Antireflexschicht nach dem Aufbringen bei einer Temperatur von mindestens 160°C gebacken wird.

13. Verfahren nach Anspruch 12, bei dem ferner ein Photoresist auf die Antireflexschicht aufgebracht wird.

14. Verfahren nach Anspruch 13, bei dem ferner mindestens ein Teil der Photoresistschicht Aktivierungsstrahlung ausgesetzt wird, die bestrahlte Photoresistschicht entwickelt wird und die entwickelte Photoresistschicht geätzt wird.

15. Verfahren nach Anspruch 8, bei dem die Antireflexschicht eine Ätzselektivität gegenüber dem Resist von mindestens 1,2 aufweist, wenn CF₄ als Ätzmittel verwendet wird.

16. Kombination eines Substrats mit einer Oberfläche und einer Antireflexschicht auf der Substratoberfläche, wobei die Antireflexschicht darin eine lichtdämpfende Verbindung und Polymerbindemittel enthält, das wiederkehrende Monomere der Formel: 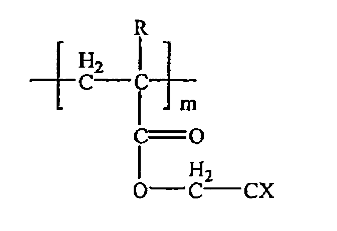 umfasst, in der R in jedem Monomer des Polymerbindemittels individuell aus der Gruppe bestehend aus Wasserstoff und C₁-bis C₈-Alkylgruppen ausgewählt ist und X in jedem Monomer des Polymerbindemittels individuell aus der Gruppe bestehend aus -HI₂, -I₃, -HF₂, -F₃, -HCl₂, -Cl₃ -HBr₂ und -Br₃ ausgewählt ist.

17. Kombination nach Anspruch 16, bei der die Antireflexschicht eine Ätzselektivität gegenüber dem Resist von mindestens 1,2 aufweist, wenn CF₄ als Ätzmittel verwendet wird.

18. Kombination nach Anspruch 16, bei der die Antireflexschicht einen k-Wert von mindestens 0,3 bei 248 nm aufweist.

19. Kombination nach Anspruch 16, bei der die Antireflexschicht einen n-Wert von mindestens 1,4 bei 248 nm aufweist.

20. Zusammensetzung nach Anspruch 1, bei der das Polymerbindemittel 20 bis 80 Gew.-% Halogenatome enthält, bezogen auf das Gesamtgewicht des Polymerbindemittels, das als 100 Gew.-% angenommen wird.

21. Verfahren zum Bilden einer Vorläuferstruktur zur Verwendung beim Herstellen von integrierten Schaltungen, wobei bei dem Verfahren eine Antireflexzusammensetzung gemäß Anspruch 20 auf die Oberfläche eines Substrats aufgebracht wird, um auf der Substratoberfläche eine Antireflexschicht zu bilden.

22. Verfahren nach Anspruch 21, bei dem ferner ein Photoresist auf die Antireflexschicht aufgebracht wird.

23. Verfahren nach Anspruch 22, bei dem ferner mindestens ein Teil der Photoresistschicht Aktivierungsstrahlung ausgesetzt wird, die bestrahlte Photoresistschicht entwickelt wird und die entwickelte Photoresistschicht geätzt wird.

24. Kombination nach Anspruch 16, bei der das Polymerbindemittel 20 bis 80 Gew.-% Halogenatome enthält, bezogen auf das Gesamtgewicht des Polymerbindemittels, das als 100 Gew.-% angenommen wird.

## Revendications

1. Composition anti-réfléchissante pouvant durcir destinée à être utilisée au cours de procédés microlithographiques, ladite composition comprenant un liant polymère et un composé qui atténue la lumière dispersé dans un système de solvant, ledit liant polymère comprenant des monomères récurrents selon la formule : 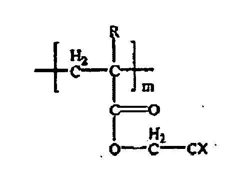 dans laquelle R dans chaque monomère du liant polymère est sélectionné de manière individuelle dans le groupe qui se compose de l'hydrogène et des alkyles Cl - C8, et X dans chaque monomère du liant polymère est sélectionné de manière individuelle dans le groupe qui se compose de -HI₂, -I₃, -HF₂, -F₃, - HCl₂, -C1₃, -HBr₂ et -Br₃.

2. Composition selon la revendication 1, dans laquelle ledit composé qui atténue la lumière est lié au liant polymère.

3. Composition selon la revendication 1, dans laquelle ladite composition comprend en outre un agent de réticulation et un catalyseur pour ledit agent de réticulation.

4. Composition selon la revendication 1, dans laquelle ladite composition présente une sélectivité de gravure vis-à-vis d'une couche protectrice au moins égale à 1,2 lorsque du CF₄ est utilisé en tant qu'agent de gravure.

5. Composition selon la revendication 1, dans laquelle le poids moléculaire moyen pondéral dudit liant polymère est compris entre 1.000 g / mol et 1.000.000 g / mol (dalton).

6. Composition selon la revendication 1, dans laquelle ladite composition présente une valeur k au moins égale à 0,3 à 248 nm.

7. Composition selon la revendication 1, dans laquelle ladite composition présente une valeur n au moins égale à 1,35 à 248 nm.

8. Procédé de formation d'une structure précurseur destinée à être utilisée dans la fabrication de circuits intégrés, ledit procédé comprenant l'étape consistant à appliquer une composition anti-réfléchissante selon la revendication 1 sur la surface d'un substrat de façon à former une couche anti-réfléchissante sur ladite surface de substrat.

9. Procédé selon la revendication 8, dans lequel ladite couche anti-réfléchissante présente une valeur k au moins égale à 0,3 à 248 nm.

10. Procédé selon la revendication 8, dans lequel ladite composition présente une valeur n au moins égale à 1,35 à 248 nm.

11. Procédé selon la revendication 8, dans lequel ladite étape d'application comprend un dépôt par centrifugation de ladite composition sur ladite surface de substrat.

12. Procédé selon la revendication 8, comprenant en outre l'étape consistant à cuire ladite couche anti-réfléchissante après ladite étape d'application à une température au moins égale à 160 °C.

13. Procédé selon la revendication 12, comprenant en outre l'étape consistant à appliquer une résine photosensible sur ladite couche anti-réfléchissante.

14. Procédé selon la revendication 13, comprenant en outre les étapes consistant à :
exposer au moins une partie de ladite couche de résine photosensible à un rayonnement d' activation ;
développer ladite couche de résine photosensible exposée ; et
graver ladite couche de résine photosensible développée.

15. Procédé selon la revendication 8, dans laquelle ladite couche anti-réfléchissante présente une sélectivité de gravure vis-à-vis d'une couche protectrice au moins égale à 1,2 lorsque du CF₄ est utilisé en tant qu'agent de gravure.

16. Combinaison d'un substrat qui présente une surface et une couche anti-réfléchissante sur ladite surface de substrat, ladite couche anti-réfléchissante comprenant à l'intérieur un composé qui atténue la lumière et un liant polymère qui comprend des monomères récurrents selon la formule : 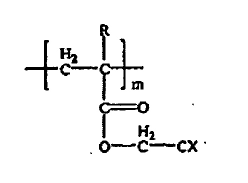 dans laquelle R dans chaque monomère du liant polymère est sélectionné de manière individuelle dans le groupe qui se compose de l'hydrogène et des alkyles C1 - C8, et X dans chaque monomère du liant polymère est sélectionné de manière individuelle dans le groupe qui se compose de -HI_{z}, -I₃, -HF₂, -F₃, - HCI₂, -Cl₃, -HBr₂ et -Br₃.

17. Combinaison selon la revendication 16, dans laquelle ladite couche anti-réfléchissante présente une sélectivité de gravure vis-à-vis d'une couche protectrice au moins égale à 1,2 lorsque du CF₄ est utilisé en tant qu'agent de gravure.

18. Combinaison selon la revendication 16, dans lequel ladite couche anti-réfléchissante présente une valeur k au moins égale à 0,3 à 248 nm.

19. Combinaison selon la revendication 16, dans lequel ladite couche anti-réfléchissante présente une valeur n au moins égale à 1,4 à 248 nm.

20. Composition selon la revendication 1, dans laquelle ledit liant polymère comprend entre 20 % en poids et 80 % en poids d'atomes d'halogène, sur la base du poids total du liant polymère considéré comme représentant 100 % en poids.

21. Procédé de formation d'une structure précurseur destinée à être utilisée dans la fabrication de circuits intégrés, ledit procédé comprenant l'étape consistant à appliquer une composition anti-réfléchissante selon la revendication 20 sur la surface d'un substrat de façon à former une couche anti-réfléchissante sur ladite surface de substrat.

22. Procédé selon la revendication 21, comprenant en outre l'étape consistant à appliquer une résine photosensible sur ladite couche anti-réfléchissante.

23. Procédé selon la revendication 22, comprenant en outre les étapes consistant à :
exposer au moins une partie de ladite couche de résine photosensible à un rayonnement d'activation ;
développer ladite couche de résine photosensible exposée ; et
graver ladite couche de résine photosensible développée.

24. Combinaison selon la revendication 16, dans laquelle ledit liant polymère comprend entre 20 % en poids et 80 % en poids d'atomes d'halogène, sur la base du poids total du liant polymère considéré comme représentant 100 % en poids.
